(19) Europäisches Patentamt
European Patent Office
Office européen des brevets

(11) EP 4 283 621 A1

(12) DEMANDE DE BREVET EUROPEEN

(43) Date de publication:
29.11.2023 Bulletin 2023/48

(21) Numéro de dépôt: 23174669.4

(22) Date de dépôt: 22.05.2023

(51) Classification Internationale des Brevets (IPC):
**G11C 11/54** (2006.01)    **G11C 13/00** (2006.01)
**G11C 11/56** (2006.01)

(52) Classification Coopérative des Brevets (CPC):
**G11C 11/54; G11C 11/56; G11C 13/0002;
G11C 13/0028; G11C 13/003; G11C 13/004;**
G11C 2013/0045; G11C 2213/15; G11C 2213/76

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**KH MA MD TN**

(30) Priorité: **23.05.2022 FR 2204938**

(71) Demandeur: **Commissariat à l'énergie atomique
et aux énergies alternatives
75015 Paris (FR)**

(72) Inventeurs:
• **HIRTZLIN, Tifenn
38054 GRENOBLE CEDEX 09 (FR)**
• **VIANELLO, Elisa
38054 GRENOBLE CEDEX 09 (FR)**
• **MOLAS, Gabriel
38054 GRENOBLE CEDEX 09 (FR)**
• **MINGUET LOPEZ, Joël
38054 GRENOBLE CEDEX 09 (FR)**

(74) Mandataire: **Brevalex
Tour Trinity
1 B Place de la Défense
92400 Courbevoie (FR)**

(54) **METHODE DE CALCUL D'UNE OPERATION MAC DANS UNE MEMOIRE RRAM DE TYPE 1S1R**

(57)      La présente invention concerne une méthode de calcul d'une opération MAC au moyen d'une mémoire RRAM 1S1R, notamment dans le domaine du calcul neuromorphique. Elle permet d'effectuer le produit scalaire entre un vecteur d'activation dont les éléments sont binaires avec un vecteur de coefficients synaptiques, quantifiés sur $M > 2$ niveaux. Le calcul comprend une première phase (Fig. 5A), dans laquelle on applique (521,541), M-1 tensions de lecture $V_{read2}, \ldots, V_{readM-1}$ aux lignes de mot correspondant à une activation positive et l'on détermine, (531,551) pour chacune de ces tensions le nombre de cellules passantes dans un ligne de bit. Dans une seconde phase (Fig. 5B), on applique (522,542) ces M-1 tensions de lecture aux lignes de mot correspondant à une activation négative et l'on détermine à nouveau (532,552), pour chacune d'entre elles, le nombre de cellules passantes dans la ligne de bit. Le produit scalaire se déduit alors de la différence entre le nombre total de cellules passantes dans la première phase et le nombre total de cellules passantes dans la seconde phase.

FIG. 5A

EP 4 283 621 A1

**Description**

**DOMAINE TECHNIQUE**

La présente invention concerne de manière générale le domaine des mémoire résistives non volatiles ou RRAM (*Resistive Random Access Memory*), dont notamment celles dites de type 1S1R, dont les cellules mémoire comprennent un sélecteur et une résistance programmable. Elle trouve notamment application dans les accélérateurs hardware pour l'apprentissage profond (*Deep Learning*), plus particulièrement dans l'implémentation d'opérations MAC (*Multiply ACcumulate*).

**ÉTAT DE LA TECHNIQUE ANTÉRIEURE**

Les réseaux de neurones artificiels sont utilisés dans de très nombreuses applications d'intelligence artificielle. Les calculs requis par ces réseaux de neurones sont généralement effectués par un logiciel exécuté par un processeur, les résultats intermédiaires étant stockés dans une mémoire. Le traitement par le processeur et les échanges importants de données entre le processeur et la mémoire conduisent à une consommation élevée d'énergie notamment pour les réseaux de grandes tailles. Or, les ressources en énergie sont parfois très limitées comme au sein des noeuds de réseaux connectés. Il en résulte que les calculs doivent être déportés dans le Cloud ou en périphérie de réseau.

L'intégration de réseaux de neurones artificiels dans les objets connectés est cependant quelquefois souhaitable pour des raisons de sécurité, de disponibilité hors connexion ou de temps de latence.

Il a été récemment proposé des mémoires résistives ou RRAM comme accélérateurs hardware à faible consommation d'énergie pour effectuer certains calculs neuromorphiques, comme les opérations MAC (*Multiply ACcumulate*) intervenant dans les produits entre matrices de poids synaptiques et vecteurs d'activation.

On pourra trouver une description de l'utilisation de mémoires résistives pour les calculs neuromorphiques dans l'article de H. Li et al. intitulé « Memristive crossbar arrays for storage and computing applications » publié dans Adv. Intell. Syst., 3, 2100017, pp. 1-26.

Les mémoires résistives sont composées de cellules comprenant chacune un élément résistif de résistance variable codant un coefficient synaptique. Dans sa forme la plus simple, une mémoire résistive implémente un réseau de neurones binaire ou BNN (*Binary Neural Network*). Chaque élément résistif d'une cellule est réalisé dans un matériau pouvant basculer de manière réversible entre un état de haute résistivité ou HRS (*High Resistance State*) et un état de faible résistivité ou LRS (*Low Resistance State*). Différentes technologies permettent de réaliser un tel basculement entre deux états de résistivité. On distingue ainsi les mémoires à changement de phase ou PCRAM (*Phase Change Random Access Memory*), les mémoires dites à pont conducteur ou CBRAM (*Conductive Bridge Random Access Memory*), les mémoires ferroélectriques ou FERAM (*FErroelectric Random Access Memory*), les mémoires à base d'oxyde ou OxRAM (*Oxide based Random Access Memory*). Dans ces mémoires, chaque cellule ne peut stocker qu'un bit de donnée, représenté par l'état de l'élément résistif.

Une méthode pour effectuer un calcul neuromorphique, plus précisément le produit d'une matrice de coefficients synaptiques d'un réseau BNN avec un vecteur dont les éléments sont les valeurs d'activation des neurones d'une couche a été décrit dans l'article de S.N. Truong intitulé « Single crossbar array of memristors with bipolar inputs for neuromorphic image recognition » publié dans IEEE Access, vol. 8, pp. 69327-69332.

Si l'on note le vecteur d'activation $\boldsymbol{a}^\ell$ de la couche $\ell$, $\boldsymbol{a}^{\ell+1}$ le vecteur d'activation de la couche $\ell + 1$, et $\boldsymbol{W}^{\ell,\ell+1}$ la matrice des coefficients synaptiques entre les deux couches, on a :

[Math. 1]

$$a^{\ell+1} = sign(W^{\ell,\ell+1}a^{\ell}) \qquad (1)$$

où $\boldsymbol{sign(a)}$ est l'opération qui donne le signe des différents éléments du vecteur $\boldsymbol{a}$. La valeur d'activation du neurone i de la couche $\ell + 1$ s'obtient ainsi à partir du signe du produit scalaire :

[Math.2]

$$a_i^{\ell+1} = sign(\boldsymbol{w}_i^{\ell,\ell+1}\boldsymbol{a}^{\ell}) = sign\left(\sum_j W_{ij}^{\ell,\ell+1}a_j^{\ell}\right) \qquad (2)$$

où $\boldsymbol{w}_i^{\ell,\ell+1}$ est le vecteur ligne correspondant à la ième ligne de la matrice $\boldsymbol{W}^{\ell,\ell+1}$. Le produit scalaire intervenant dans l'expression (2) mesure simplement la similarité entre le vecteur $w_i^{\ell,\ell+1}$ stocké dans la RRAM et le vecteur d'entrée $a^\ell$

[Math.3]

$$w_i^{\ell,\ell+1} \cdot a^\ell = popcount\left(\overline{w_i^{\ell,\ell+1} \oplus a^\ell}\right) = popcount\left(XNOR\left(w_i^{\ell,\ell+1}, a^\ell\right)\right) \quad (3)$$

où l'opération XNOR s'entend sur chacun des bits des deux vecteurs et *popcount* est la somme (positive ou négative) des bits du vecteur résultant.

L'article précité propose de calculer le produit scalaire $w_i^{\ell,\ell+1} a^\ell$ en appliquant en entrée de la mémoire RRAM le mot binaire $a^\ell$ en représentation polaire ($\tilde{a}^\ell = a^\ell - \overline{a}^\ell$) et en effectuant une lecture de courant sur la ligne de sortie i correspondante, la sommation $\sum_j W_{ij}^{\ell,\ell+1} a_j^\ell$ résultant simplement de la loi de Kirchhoff.

Des technologies de mémoires, dont certaines utilisables pour calcul d'adresses MAC, sont divulguées par le document de brevet US 2019/362787 et par la publication de J-M. Hung, X. Li, J. Wu et M-F. Chang, "Challenges and Trends inDeveloping Nonvolatile Memory-Enabled Computing Chips for Intelligent Edge Devices," IEEE Transactions on Electron Devices, vol. 67, no. 4, pp. 1444-1453, April 2020, doi: 10.1109/TED.2020.2976115.

Ainsi récemment, des mémoires résistives permettant de stocker plusieurs bits par cellule ont vu le jour. L'article de E. Esmanhotto et al. intitulé « High-density monolithically integrated multiple 1T1R multiple-level cell for neural networks » publié dans IEEE International Electron Devices Meeting (IEDM) Proc. Dec. 2020, pp. 36.5.1-36.5.4 décrit notamment une cellule résistive multi-niveau ou MLC (*Multi-Level Cell*) de type 1T1R c'est-à-dire constituée d'un élément résistif et d'un transistor permettant de bloquer ou donner l'accès à l'élément résistif pour des opérations de lecture ou d'écriture tout en limitant les courants de fuite dans le reste de la matrice.

Les cellules 1T1R ne permettent toutefois pas d'atteindre un niveau d'intégration élevé en raison de la surface nécessaire pour réaliser le transistor d'accès. Pour cette raison, on préfère utiliser des cellules de type 1S1R comprenant un sélecteur non linéaire et un élément résistif en série, le sélecteur étant généralement un interrupteur à seuil ovonique ou OTS (*Ovonic Threshold Selector*).

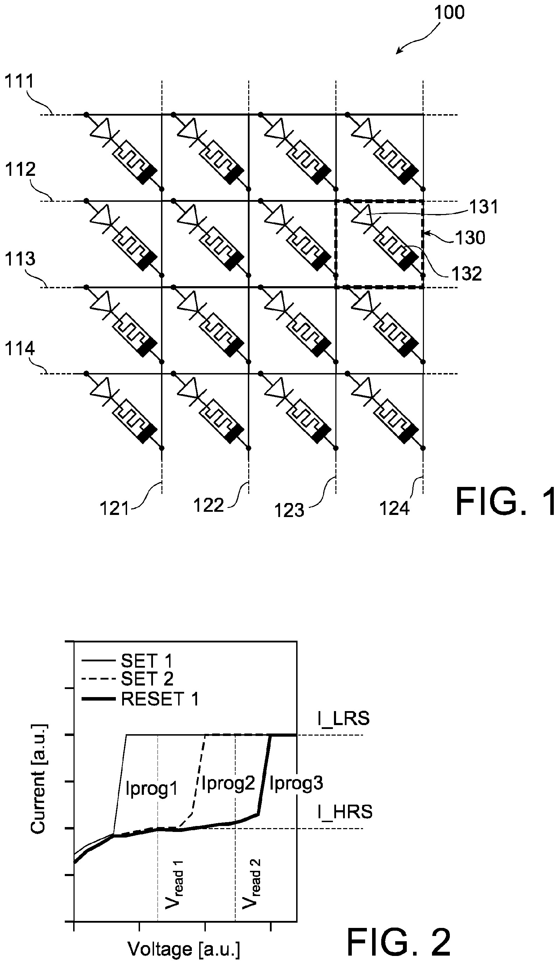

Une mémoire résistive de type 1S1R est représentée en Fig. 1. Celle-ci est constituée d'une matrice, 100, de lignes d'entrée, 111, 112, 113, 114 et de lignes de sortie, 121, 122, 123, 124 selon un agencement de type cross-bar. Chaque cellule mémoire 130 est composée d'un sélecteur non linéaire 131 et d'un élément de mémorisation 132 monté en série entre une ligne d'entrée (ou ligne de mot) et une ligne de sortie (ou ligne de bit).

La Fig. 2 illustre schématiquement les caractéristiques tension-courant lors d'une opération de lecture d'une cellule mémoire de type 1S1R multiniveau, ici à 3 niveaux de programmation. Les trois niveaux de programmation correspondent respectivement à des caractéristiques Iprog1, Iprog2, Iprog3, sensiblement translatées en tension les unes par rapport aux autres. Une lecture en courant de la cellule (c'est-à-dire en injectant un courant de lecture dans celle-ci) peut ne pas permettre de déterminer l'état de la cellule si le courant de lecture est supérieur à une valeur maximale I_LRS, ou encore si le courant de lecture est inférieur à une valeur minimale I_HRS. L'application d'une tension à son entrée et la lecture du courant de sortie correspondant ne permet pas non plus de discriminer les différents états de la cellule. Ainsi, par exemple, une lecture à la tension Vread1, ne permet pas de distinguer les second et troisième états et une lecture à la tension Vread2 ne permet pas de distinguer les premier et second états.

Il est par conséquent difficile de lire la valeur d'un coefficient synaptique stockée dans une cellule mémoire RRAM MLC et *a fortiori* de réaliser un calcul neuromorphique tel qu'une opération MAC au moyen d'une telle mémoire RRAM MLC.

Un objet de la présente invention est par conséquent de proposer une méthode pour effectuer un calcul neuromorphique et en particulier une opération MAC au moyen d'une mémoire RRAM MLC.

## EXPOSÉ DE L'INVENTION

La présente invention est définie par une méthode de calcul d'une opération MAC pour fournir le produit scalaire entre un premier vecteur, dont les éléments sont des valeurs binaires, et un second vecteur dont les éléments sont des valeurs quantifiées sur M > 2 niveaux, ladite opération étant réalisée au moyen d'une mémoire composée de cellules mémoire comportant une pluralité de lignes de mot et une pluralité de lignes de bit, une cellule mémoire reliant chaque ligne de mot à chaque ligne de bit selon une configuration crossbar, chaque cellule mémoire pouvant prendre une pluralité $M$ d'états, chaque état étant associé à une caractéristique courant-tension de la cellule, les cellules mémoire d'une ligne de bit stockant les éléments du second vecteur, caractérisée en ce que chaque cellule mémoire est lue en appliquant successivement $M$ - 1 tensions $V_{read_1}$, $V_{read_2}$,..., $V_{read_{M-1}}$ sur sa ligne de mot et en lisant les courants de sortie correspondants sur sa ligne de bit, lesdits courants de sortie donnant une représentation sous forme de code thermométrique de l'élément stocké, ladite méthode comprenant :

- une première phase de lecture dans laquelle on sélectionne les lignes de mot correspondant aux éléments du premier vecteur ayant une première valeur binaire, on applique successivement aux lignes de mot ainsi sélectionnées les tensions $V_{read_1}$, $V_{read_2}$,..., $V_{read_{M-1}}$, on lit les courants de sortie correspondants sur la ligne de bit et on déduit à chaque lecture le nombre de cellules passantes sur cette ligne de bit ;
- une seconde phase de lecture dans laquelle on sélectionne les lignes de mot correspondant aux éléments du premier vecteur ayant une seconde valeur binaire, on applique successivement aux lignes de mot ainsi sélectionnées les tensions $V_{read_1}$, $V_{read_2}$,..., $V_{read_{M-1}}$, on lit les courants de sortie correspondants sur la ligne de bit et on déduit à chaque lecture le nombre de cellules passantes sur cette ligne de bit ;
- on calcule la différence entre le nombre total de cellules passantes dans la première phase et le nombre total de cellules passantes dans la seconde phase ;
- on corrige la différence ainsi obtenue d'un biais égal à la différence entre le nombre d'éléments du premier vecteur ayant la première valeur binaire et le nombre d'éléments du second vecteur ayant la seconde valeur binaire, pour en déduire ledit produit scalaire entre le premier vecteur et le second vecteur.

Avantageusement, les cellules mémoires sont réalisées au moyen d'un sélecteur ovonique en série avec un élément résistif pouvant être programmé dans un état de faible résistivité (LRS) ou un élément de haute résistivité (HRS).

Le premier vecteur peut être un vecteur d'activation dont les éléments sont les valeurs d'activation d'une couche de neurones, les valeurs d'activation pouvant prendre les valeurs +1 ou -1.

Le second vecteur peut être un vecteur de coefficients synaptiques de synapses entre ladite couche de neurones et la couche suivante d'un réseau de neurones quantifié sur M niveaux.

Les M valeurs quantifiées possibles des coefficients synaptiques sont typiquement égales à

$$-1, -1 + \frac{2}{M-1}, .., 1 - \frac{2}{M-1}, +1$$ .

Dans ce cas, le produit scalaire peut se déduire de la différence entre le nombre total de cellules passantes dans la première phase et le nombre total de cellules passantes dans la seconde phase, corrigée du biais, au moyen d'une opération de normalisation transformant un entier $X$ en une valeur quantifiée de coefficient synaptique,

$$-1 + \frac{2}{M-1} X$$ .

La mémoire peut être une mémoire RRAM de type 1S1R ou une mémoire à trois terminaux.

## BRÈVE DESCRIPTION DES DESSINS

D'autres caractéristiques et avantages de l'invention apparaîtront à la lecture d'un mode de réalisation préférentiel de l'invention, fait en référence aux figures jointes parmi lesquelles :

La Fig. 1, déjà décrite, représente, de manière schématique, une mémoire résistive de type 1S1R ;
La Fig. 2, déjà décrite, représente, de manière schématique, les caractéristiques tension-courant d'une cellule mémoire résistive 1S1R multi-niveau selon le niveau programmé dans la cellule ;
La Fig. 3A représente de manière schématique deux phases de lecture successives d'une mémoire RRAM 1S1R illustrant le principe de calcul d'une opération MAC selon la présente invention ;
La Fig. 3B représente de manière schématique, la caractéristique tension-courant d'une cellule mémoire résistive 1S1R selon le bit stocké dans la cellule ;
Les Fig. 3C et Fig. 3D représentent deux tables de vérité permettant de réaliser de manière séquentielle une opération XNOR dans une mémoire RRAM de type 1S1R ; La Fig. 4A représente de manière schématique deux phases de lecture successives d'une mémoire RRAM 1S1R multi-niveau pour le calcul d'une opération MAC selon un exemple de réalisation de la présente invention ;
La Fig. 4B représente, de manière schématique, la caractéristique tension-courant d'une cellule mémoire résistive 1S1R multi-niveau utilisée dans la Fig. 4A ;
Les Fig. 4C et Fig. 4D représentent de manière schématique, deux tables de vérité permettant de réaliser de manière séquentielle une opération produit dans une mémoire RRAM de type 1S1R multi-niveau ;

Les Fig. 5A et Fig. 5B représentent respectivement une première phase de lecture et une seconde phase de lecture dans une mémoire RRAM MLC, mises en oeuvre dans une méthode de calcul d'une opération MAC selon un mode général de réalisation de l'invention ; et

La Fig. 6 représente une phase de combinaison des valeurs lues dans les première et seconde phases de lecture, mise en oeuvre dans une méthode de calcul d'une opération MAC selon un mode général de réalisation de l'invention.

## EXPOSÉ DÉTAILLÉ DE MODES DE RÉALISATION PARTICULIERS

Nous considérerons dans la suite à titre d'exemple non limitatif une mémoire RRAM MLC c'est-à-dire dont les cellules mémoire sont capables de stocker une information sur M > 2 niveaux (ou états), autrement une information de plus d'un bit. En outre, on supposera que cette mémoire est une matrice crossbar de type 1S1R, c'est-à-dire dont les cellules mémoires comprennent chacune un sélecteur et un élément résistif programmable.

D'autres types de mémoire peuvent être utilisés pour la mise en oeuvre de la présente invention, par exemple une mémoire à trois terminaux, comme des mémoires FeFET ou des mémoires flash.

Par ailleurs, de manière générale la présente invention peut être mise en oeuvre avec différents types d'élément sélecteur. Cet élément est typiquement un sélecteur à seuil ovonique ou OTS. Toutefois, l'homme du métier comprendra que tout sélecteur susceptible de pouvoir se déclencher à une ou plusieurs valeurs de seuil pourra être utilisé par l'homme du métier sans sortir du cadre de la présente invention. Par exemple, le sélecteur peut être également un sélecteur à conduction mixte ionique-électronique ('MIEC', de l'Anglais Mixed Ionic Electronic conduction), un sélecteur à transition métal-isolant ('MIT', de l'Anglais Metal Insulator Transition), ou encore un sélecteur de type diode ou un sélecteur volatil filamentaire.

Dans un but de simplification de l'exposé, nous considérerons toutefois au préalable une cellule mémoire 1S1R à seulement M = 2 niveaux. Dans un tel cas, la cellule peut être programmée dans un état de résistivité élevée (HRS) et donc de faible conductance, notée $G_{off}$, ou bien dans un état de faible résistivité (LRS) et donc de conductance élevée, notée $G_{on}$.

Une idée à l'origine de la présente invention est d'appliquer séquentiellement une première tension et une seconde tension de lecture, et de déduire des courants correspondants, lus en sortie, le résultat de l'opération $a.w$ où $a$ est une valeur d'activation binaire polaire ($a = \pm 1$) et w est la valeur du poids synaptique binaire stocké dans la cellule ($w = \pm 1$). La valeur $w = -1$ est stockée en programmant la cellule avec la conductance $G_{off}$ et la valeur w = +1 est stockée avec la conductance $G_{on}$. La première tension de lecture est choisie nulle si la valeur d'activation est égale à -1 et égale à $V_{read}$ avec $V_{TH-LRS} < V_{read} < V_{TH-HRS}$ où $[V_{TH-LRS}, V_{TH-HRS}]$ est une plage de tension dans laquelle la conductance prend la valeur $G_{off}$ si $w = -1$ et la valeur $G_{on}$ si $w = +1$.

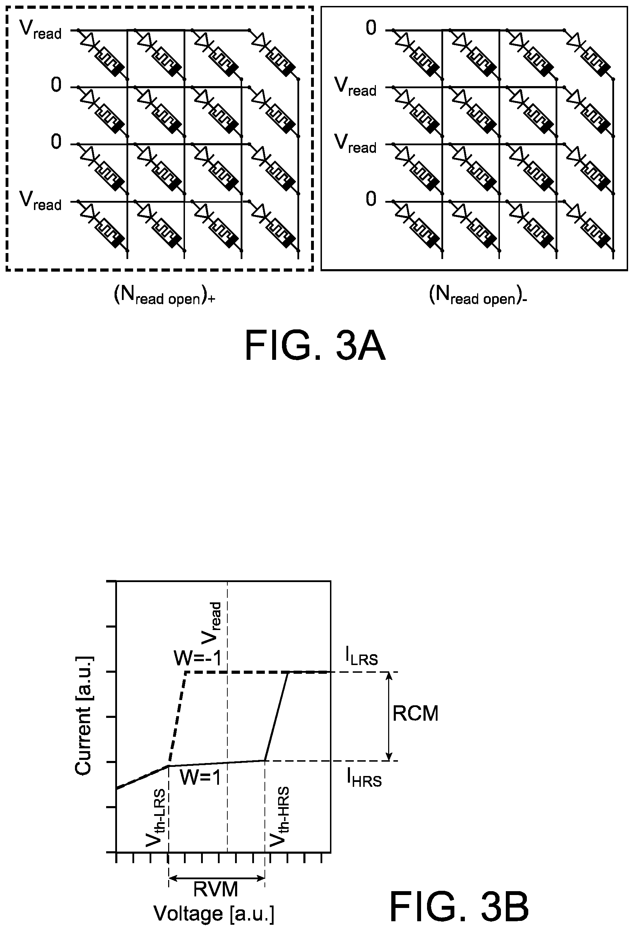

La Fig. 3A illustre schématiquement les deux phases de lecture d'une mémoire 1S1R permettant d'effectuer le calcul d'une opération MAC. On a supposé dans cet exemple que le vecteur d'activation était égal à $(+1,-1,-1,+1)^T$. Dans une première phase, on applique en entrée de la mémoire la tension de lecture $V_{read}$ aux lignes de mot correspondant aux valeurs d'activation positives et on lit le courant de sortie pour chaque ligne de bit. Celui-ci est égal à la somme des courants dans les différentes cellules mémoire de la colonne. De manière similaire, dans une seconde phase, on applique en entrée de la mémoire la tension de lecture $V_{read}$ aux lignes de mot correspondant aux valeurs d'activation négatives et on lit à nouveau le courant de sortie pour chaque ligne de bit.

On considère maintenant le comportement d'une telle cellule mémoire lors de ces deux phases de lecture.

La caractéristique tension-courant d'une cellule mémoire de type à deux niveaux est représenté en Fig. 3B. On voit que la tension de lecture $V_{read}$ a été choisie telle que $V_{TH-LRS} < V_{read} < V_{TH-HRS}$, ici sensiblement au milieu de la plage $[V_{TH-LRS}, V_{TH-HRS}]$.

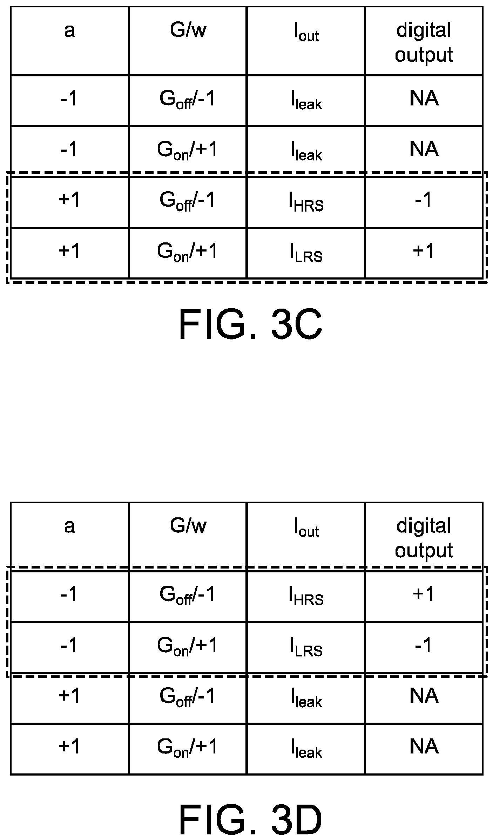

La Fig. 3C représente schématiquement la table de vérité d'une cellule mémoire à deux niveaux lors de la première phase de lecture. Etant donné que seules les lignes correspondant à des valeurs d'activation positives sont lues, seule la partie entourée en bas du tableau est pertinente. Lorsque la cellule n'est pas lue, c'est-à-dire lorsque son entrée est à la masse, seul un courant de fuite (provenant des cellules lues voisines), $I_{leak}$, de valeur négligeable, traverse la cellule en question. En revanche, lorsque la cellule est lue, le courant de sortie dépend de son état. Si son état est HRS (haute résistivité, conductance $G_{off}$), correspondant à un coefficient synaptique stocké égal à -1, le courant de sortie est égal à $I_{HRS}$. A l'inverse, si son état est LRS (faible résistivité, conductance $G_{on}$), correspondant à un coefficient synaptique stocké égal à +1, le courant de sortie est égal à $I_{LRS}$. Dans le premier cas, on assigne conventionnellement -1 à un courant lu égal à $I_{HRS}$ et +1 à un courant lu égal à $I_{LRS}$.

La Fig. 3D représente schématiquement la table de vérité de la même cellule lors de la seconde phase de lecture. Etant donné que seules les lignes correspondant à des valeurs d'activation négatives, seule la partie entourée en haut du tableau est pertinente. Ici encore, lorsque la cellule n'est pas lue, seul un courant de fuite, $I_{leak}$, traverse la cellule en question. En revanche, lorsque la cellule est lue, le courant de sortie dépend de son état. Si son état est HRS (haute résistivité, conductance $G_{off}$), correspondant à un coefficient synaptique stocké égal à -1, le courant de sortie est égal à $I_{HRS}$. A l'inverse, si son état est LRS (faible résistivité, conductance $G_{on}$), correspondant à un coefficient synaptique stocké égal à +1, le courant de sortie est égal à $I_{LRS}$. Dans le premier cas, on assigne conventionnellement +1 à un courant lu égal à $I_{HRS}$ et -1 à un courant lu égal à $I_{LRS}$. On remarque que si l'on regroupe les deux parties entourées de la table de vérité, on obtient celle de *XNOR(w,a)*, c'est-à-dire celle d'une comparaison de la valeur d'activation avec la valeur du coefficient synaptique.

Si l'on retourne maintenant à la Fig. 3A et que l'on considère une colonne donnée, le courant lu lors de la première phase de lecture est de l'ordre de $(N_{read\ open})_+ I_{LRS}$ où $(N_{read\ open})_+$ est le nombre de cellules passantes dans la colonne lors de la première phase de lecture. De manière similaire, le courant lu lors de la seconde phase de lecture est de l'ordre de $(N_{read\ open})_- I_{LRS}$ où $(N_{read\ open})_+$ est le nombre de cellules passantes dans la colonne lors de la seconde phase de lecture. Le nombre de cellules passantes $(N_{read\ open})_-$ dans la seconde phase est soustrait au nombre de cellules passantes dans la première phase, ce qui représenté dans la figure par l'expression $(N_{read\ open})_+ - (N_{read\ open})_-$.

Si le nombre de valeurs d'activation positives est égale au nombre d'activation négatives, la différence $(N_{read\ open})_+ - (N_{read\ open})_-$ n'est autre que le produit scalaire *w. a* où les éléments (binaires) du vecteur *w* sont stockés dans les cellules de la colonne. Toutefois, de manière générale, il faut corriger le résultat obtenu d'un biais lié à la différence entre le nombre de valeurs d'activation positives et celui de valeurs d'activation négatives

[Math. 4]

$$\boldsymbol{w.a} = \left(N_{read\ open}\right)_+ - \left(N_{read\ open}\right)_- - \left(\sum a_i^+ - \sum a_i^-\right) \qquad (4)$$

Le premier (resp. second) terme de l'expression (4) correspond au nombre de cellules passantes de la ligne de bit lorsque la tension de lecture $V_{read}$ est appliquée aux lignes de mot correspondant aux valeurs d'activation positives (resp. négatives) de vecteur d'activation *a* .

Le second terme de l'expression (4) correspond à la valeur de biais résultant de la différence entre le nombre de valeurs d'activation positives et le nombre de valeurs d'activation négatives dans *a*.

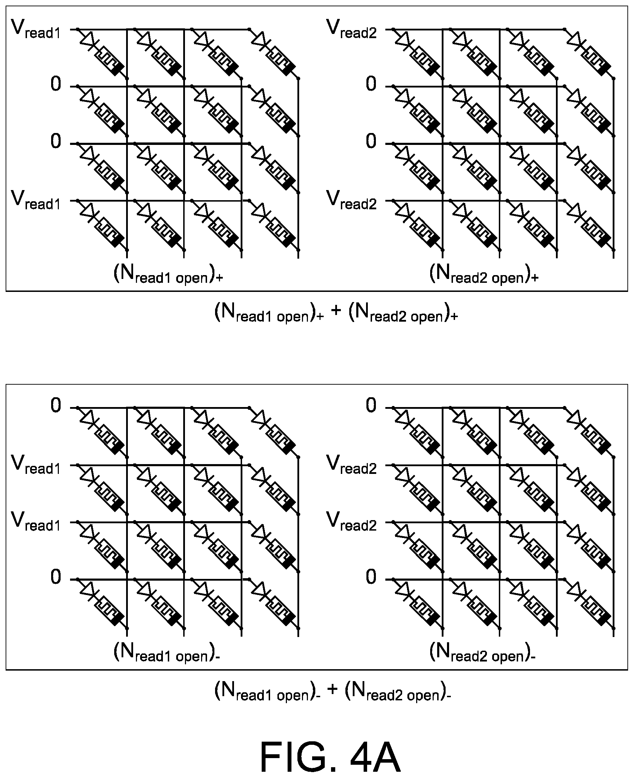

La Fig. 4A illustre schématiquement les deux phases de lecture d'une mémoire 1S1R multi-niveau permettant d'effectuer le calcul d'une opération MAC. Comme dans le cas précédent, on a supposé dans cet exemple que le vecteur d'activation était égal à $(+1,-1,-1,+1)^T$. Les cellules mémoire sont ici à 3 niveaux.

Dans une première phase de lecture, on applique en entrée de la mémoire, dans une première étape, une première tension de lecture $V_{read1}$ aux lignes de mot correspondant aux valeurs d'activation positives. Cette opération est répétée dans une seconde étape, en appliquant une seconde tension de lecture $V_{read2}$ aux mêmes lignes de mot.

Pour chaque ligne de bit, le courant lu est égal à la somme des courants dans les différentes cellules mémoire de la colonne associée. Le courant lu dans la première étape est ainsi de l'ordre de $(N_{read1\ open})_+ \cdot I_{LRS}$ où $(N_{read1\ open})_+$ est le nombre de cellules de mémoire passantes dans la colonne. De manière similaire, le courant lu dans la seconde étape est de l'ordre de $(N_{read2\ open})_+ I_{LRS}$. Les courants ainsi lus à la première et à la seconde étape sont sommés pour chaque ligne de bit, ce qui est représenté dans la figure par l'expression $((N_{read1\ open})_+ + (N_{read2\ open})_+) I_{LRS}$.

Dans une seconde phase de lecture, on applique en entrée de la mémoire, dans une première étape la première tension de lecture $V_{read1}$ aux lignes de mot correspondant aux valeurs d'activation négatives. Cette opération est répétée dans une seconde étape, en appliquant la seconde tension de lecture $V_{read2}$ à ces mêmes lignes de mot.

Pour chaque ligne de bit, le courant lu dans la première étape est ainsi de l'ordre de $(N_{read1\ open})_- \cdot I_{LRS}$ où $(N_{read1\ open})_-$ est le nombre de cellules de mémoire passantes dans la colonne. De manière similaire, le courant lu dans la seconde étape est de l'ordre de $(N_{read2\ open})_- I_{LRS}$. Les courants ainsi lus à la première et à la seconde étape sont sommés pour chaque ligne de bit, ce qui est représenté dans la figure par l'expression $((N_{read1\ open})_- + (N_{read2\ open})_-) I_{LRS}$.

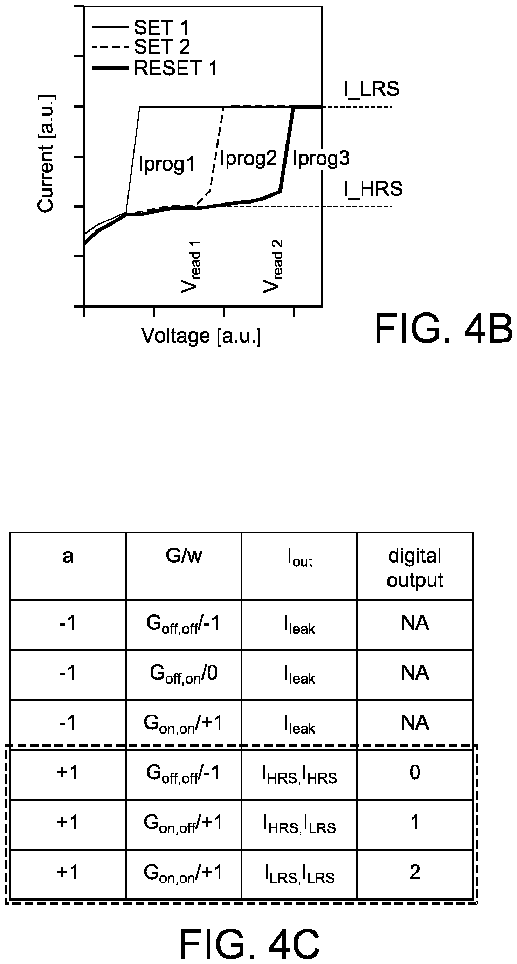

On considère maintenant le comportement d'une cellule mémoire lors des deux phases de lecture. La caractéristique tension-courant d'une cellule mémoire a été représentée en Fig. 4B. Dans l'exemple illustré, le nombre M de niveaux est égal à 3, autrement dit, la cellule peut être programmée dans 3 états différents. Les 3 niveaux de programmation sont discriminés au moyen d'une lecture à la première tension $V_{read1}$ et d'une lecture à la seconde tension $V_{read2}$. Lorsque la lecture aux tensions $V_{read1}$, $V_{read2}$ donne respectivement $I_{HRS}$, $I_{HRS}$, la cellule est programmée dans un premier état correspondant à la caractéristique Iprog1(V). Lorsque la lecture aux tensions $V_{read1}$, $V_{read2}$ donne respectivement $I_{HRS}$, $I_{LRS}$, la cellule est programmée dans un second état correspondant à la caractéristique Iprog2(V). Enfin, lorsque la lecture aux tensions $V_{read1}$, $V_{read2}$ donne respectivement $I_{LRS}$, $I_{LRS}$, la cellule est programmée selon un troisième état correspondant à la caractéristique Iprog3(V).

Chaque cellule mémoire peut donc coder un coefficient synaptique susceptible de prendre trois valeurs distinctes : -1, 0, +1.

La Fig. 4C représente schématiquement la table de vérité d'une cellule mémoire à 3 niveaux lors de la première phase de lecture. Etant donné que seules les lignes correspondant à des valeurs d'activation positives sont lues, seule la partie entourée en bas du tableau est pertinente. Lorsque la cellule n'est pas lue, c'est-à-dire lorsque son entrée est à la masse, seul un courant de fuite (provenant des cellules lues voisines), $I_{leak}$, de valeur négligeable, traverse la cellule en question. En revanche, lorsque la cellule est lue, le courant de sortie dépend de son état. Dans le premier état, correspondant à un coefficient synaptique stocké égal à -1, les courants de sortie respectivement lus à $V_{read1}$, $V_{read2}$ sont égaux à $I_{HRS}$, $I_{HRS}$. La valeur numérique attribuée, égale au nombre de fois que la cellule est conductrice lors de la lecture, est égale à 0. Dans le second état, correspondant à un coefficient synaptique stocké égal à 0, les courants de sortie respectivement lus à $V_{read1}$, $V_{read2}$ sont égaux à $I_{HRS}$, $I_{LRS}$ et la valeur numérique attribuée est égale à 1. Enfin dans le troisième état, correspondant à un coefficient synaptique stocké égal à +1, les courants de sortie respectivement lus à $V_{read1}$, $V_{read2}$ sont égaux à $I_{LRS}$, $I_{LRS}$ et la valeur numérique attribuée est égale à 2.

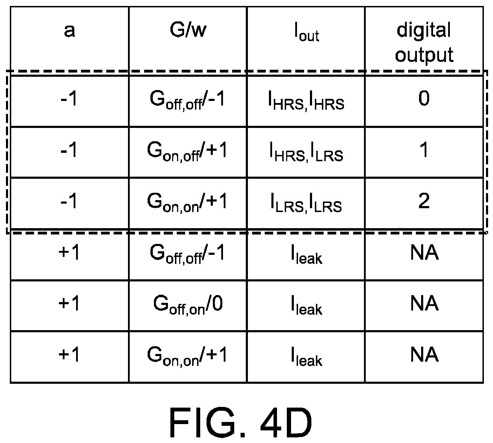

La Fig. 4D représente schématiquement la table de vérité d'une cellule mémoire à 3 niveaux lors de la seconde phase de lecture. Etant donné que seules les lignes correspondant à des valeurs d'activation négatives sont lues, seule la partie entourée en haut du tableau est pertinente. Lorsque la cellule n'est pas lue (entrée à la masse), seul un courant de fuite, $I_{leak}$, la traverse. En revanche, lorsque la cellule est lue, le courant de sortie dépend de son état. Dans le premier état, correspondant à un coefficient synaptique stocké égal à -1, les courants de sortie respectivement lus à $V_{read1}$, $V_{read2}$ sont égaux à $I_{HRS}$, $I_{HRS}$. La valeur numérique attribuée, égale au nombre de fois que la cellule est conductrice lors de la lecture, est égale à 0. Dans le second état, correspondant à un coefficient synaptique stocké égal à 0, les courants de sortie respectivement lus à $V_{read1}$, $V_{read2}$ sont égaux à $I_{HRS}$, $I_{LRS}$ et la valeur numérique attribuée est égale à 1. Enfin dans le troisième état, correspondant à un coefficient synaptique stocké égal à +1, les courants de sortie respectivement lus à $V_{read1}$, $V_{read2}$ sont égaux à $I_{LRS}$, $I_{LRS}$ et la valeur numérique attribuée est égale à 2.

Lorsque le nombre de valeurs d'activation positives est égal au nombre d'activation négatives, la différence entre la somme $(N_{read1\ open})_+$ + $(N_{read2\ open})_+$ représentative des courants lus dans la première phase et la somme $(N_{read1\ open})_-$ + $(N_{read2\ open})_-$ représentative des courants lus dans la seconde phase pour une même ligne de bit fournit le produit scalaire $\boldsymbol{w.a}$ (les éléments du vecteur $\boldsymbol{w}$ stockés dans les cellules de la colonne pouvant chacun prendre 3 niveaux). En revanche, comme précédemment, lorsque le nombre de valeurs d'activation positives diffère du nombre de valeurs d'activation négatives, le résultat obtenu est à corriger d'un biais lié à la différence entre le nombre de valeurs d'activation positives et celui de valeurs d'activation négatives, à savoir :

[Math. 5]

$$\boldsymbol{w.a} = \left( \left( N_{read1\ open} \right)_+ + \left( N_{read2\ open} \right)_+ \right) - \left( \left( N_{read1\ open} \right)_- + \right.$$

$$\left. \left( N_{read2\ open} \right)_- \right) - \left( \sum a_+ - \sum a_- \right) (5)$$

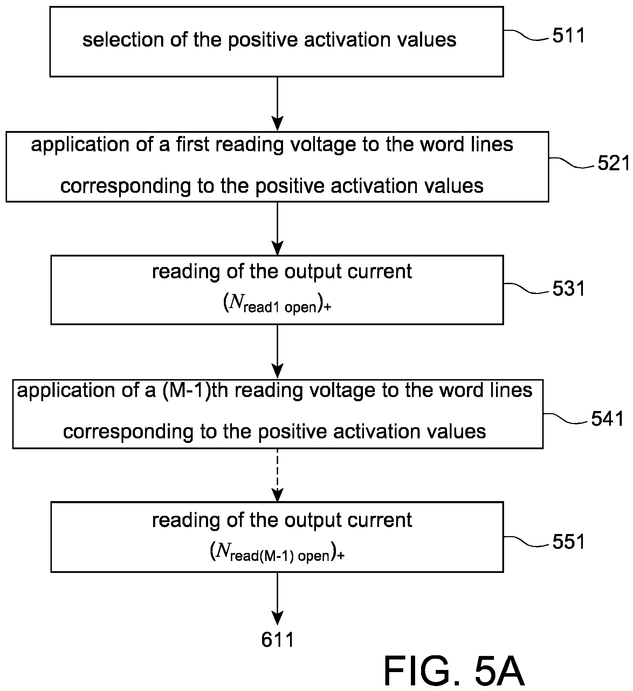

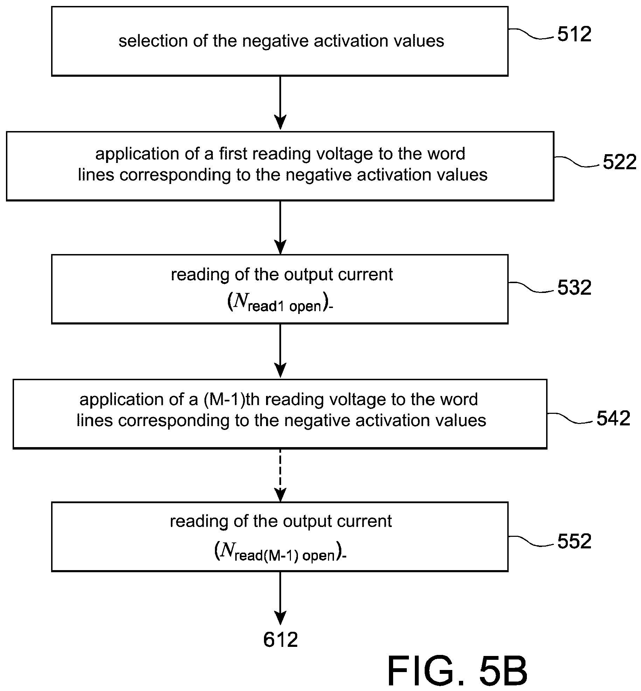

Les Fig. 5A et 5B représentent respectivement une première phase de lecture et une seconde phase de lecture dans une mémoire RRAM MLC, mises en oeuvre dans une méthode de calcul d'une opération MAC selon un mode général de réalisation de l'invention.

Dans ce mode de réalisation, le vecteur d'activation de la couche de neurones est composé d'éléments représentant soit une valeur d'activation positive ( $a_i^+ = +1$ ), soit une valeur d'activation négative ( $a_i^- = -1$ ). Les coefficients synaptiques peuvent prendre $M$ valeurs distinctes. Chaque cellule mémoire RRAM MC peut stocker un tel coefficient synaptique en pouvant prendre Métats distincts, chaque état associé à une caractéristique courant-tension de la cellule (Iprog$_1$(V)...Iprog$_{M-1}$(V)). Les lectures des courants de sortie aux tensions de lecture, $V_{read_1}$, $V_{read_2}$,..., $V_{read_{M-1}}$ permettent de décoder la valeur du coefficient synaptique stockée dans la cellule. Selon un mode préféré de réalisation, la lecture aux tensions $V_{read1}$, $V_{read2}$,..., $V_{read_{M-1}}$ permet d'obtenir une représentation de ce coefficient sous la forme d'un code thermométrique. Ainsi l'état $m \in \{0,..,M-1\}$ pourra correspondre de manière biunivoque aux courants de sortie lus :

$$I_{read_1} = I_{LRS}, \ldots, I_{read_{m-1}} = I_{LRS}, I_{read_m} = I_{HRS}, \ldots, I_{read_{M-1}} = I_{HRS}.$$

Alternativement, on comprend que cette correspondance puisse être inversée, l'état $m$ étant alors associé aux courants de sortie lus :

$$I_{read_1} = I_{HRS}, \ldots, I_{read_{m-1}} = I_{HRS}, I_{read_m} = I_{LRS}, \ldots, I_{read_{M-1}} = I_{LRS}.$$

Quelle que soit la convention de codage utilisée, la première phase correspond à l'application des tensions de lecture successives $V_{read_1}$, $V_{read_2}$,..., $V_{read_{M-1}}$ aux lignes de mot correspondant aux valeurs d'activation positives du vecteur d'activation et la seconde phase correspond à l'application de ces mêmes tensions successives aux lignes de mot correspondant aux valeurs d'activation négatives du vecteur d'activation.

Ainsi, en Fig. 5A, seules les lignes de mots de la mémoire correspondant aux valeurs d'activation positives sont sélectionnées en 511. On applique en 521 la tension $V_{read_1}$ aux lignes ainsi sélectionnées et on lit en 531 le courant de sortie sur la ligne de bit dans laquelle sont stockés les coefficients synaptiques. On détermine à partir du courant ainsi lu le nombre $(N_{read1\ open})_+$ de cellules mémoire passantes sur la ligne de bit. Cette détermination est possible dans la mesure où $I_{LRS} > N . I_{HRS}$ où Nest la taille du vecteur d'activation.

Cette opération est ensuite répétée en appliquant aux lignes de mot sélectionnées les tensions $V_{read_2},...,$ $V_{read_{M-1}}$. La dernière opération de lecture est représentée en 541 et la détermination du nombre correspondant de cellules mémoire passantes sur la ligne de bit, en 551.

La Fig. 5B, seules les lignes de mots de la mémoire correspondant aux valeurs d'activation négatives sont sélectionnées en 512. On applique en 522 la tension $V_{read_1}$ aux lignes ainsi sélectionnées et on lit en 532 le courant de sortie sur la ligne de bit dans laquelle sont stockés les coefficients synaptiques. On détermine à partir du courant ainsi lu le nombre $(N_{read1\ open})_-$ de cellules mémoire passantes sur la ligne de bit.

Cette opération est ensuite répétée en appliquant aux lignes de mot sélectionnées les tensions $V_{read_2},...,$ $V_{read_{M-1}}$. La dernière opération de lecture est représentée en 542 et la détermination du nombre correspondant de cellules mémoire passantes sur la ligne de bit, en 552.

On notera que les première et seconde phases de lecture pourront être entrelacées. Par exemple, on pourra procéder en appliquant successivement les tensions $V_{read_1}$, $V_{read_2},...,V_{read_{M-1}}$ et en sélectionnant dans une première étape les lignes de mot correspondant aux valeurs d'activation positives et dans une seconde étape celles correspondant aux valeurs d'activation négatives.

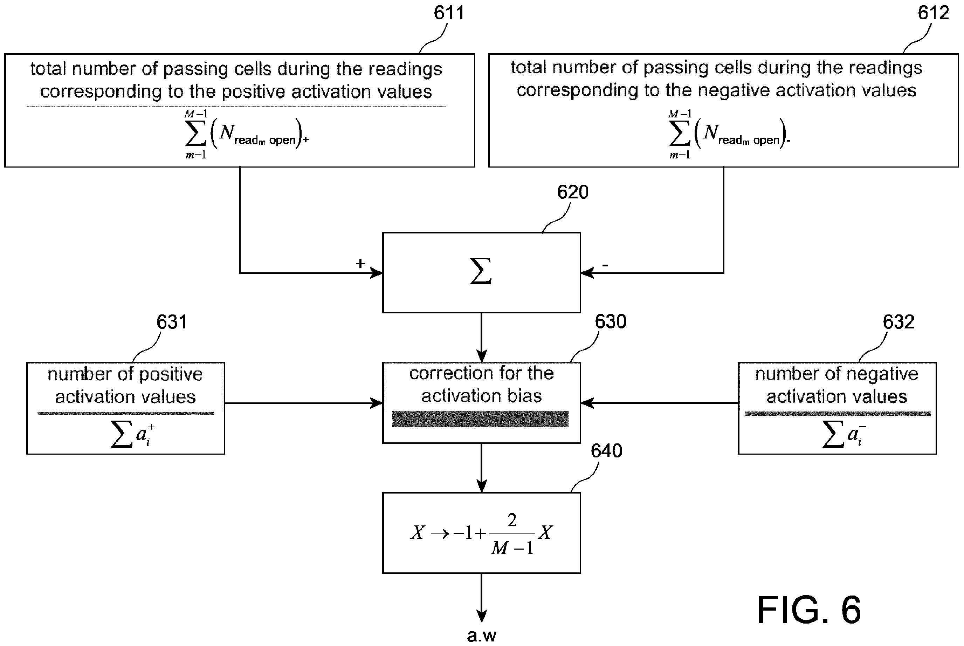

La Fig. 6 représente une phase de combinaison des valeurs lues dans les première et seconde phases de lecture pour le calcul de l'opération MAC.

Le nombre total de cellules mémoire passantes lors de la première phase de lecture est obtenu en sommant, en 611, les nombres de cellules mémoire passantes à chaque étape de lecture de cette phase, soit

$$\sum_{m=1}^{M-1}\left(N_{read_m\ open}\right)_+$$

. De même, le nombre total de cellules mémoire passantes lors de la seconde phase de lecture est obtenu, en 612, soit $\sum_{m=1}^{M-1}\left(N_{read_m\ open}\right)_-$ . On calcule ensuite en 620 la différence entre la somme des cellules passantes dans la première phase et la somme des cellules passantes dans la seconde phase.

On corrige cette différence en 630 en soustrayant du résultat un biais égal à la différence entre le nombre de valeurs d'activation positives et le nombre de valeurs d'activation négatives dans le vecteur d'activation.

La différence ainsi obtenue peut ensuite être normalisée en 640 pour passer de la plage de variation du nombre de cellules passantes à la plage de variation des valeurs quantifiées possibles des coefficients synaptiques. Ainsi, par exemple, si les valeurs quantifiées possibles d'un coefficient synaptique sont $-1, -1+\frac{2}{M-1},..,1-\frac{2}{M-1},+1$ ,

l'opération de normalisation consistera à transformer tout nombre entier $X$ en une valeur quantifiée $-1+\frac{2}{M-1}X$ .

Le résultat obtenu n'est autre que celui de l'opération MAC, $\sum_{i=1}^{N}w_i a_i$ autrement dit du produit scalaire **w.a**. Ce calcul peut être effectué en parallèle pour toutes les lignes de bit de la mémoire. Ainsi, le vecteur d'activation de la couche suivante du réseau de neurones peut être calculé de manière rapide, y compris lorsque les coefficients synaptiques quantifiés sur plus de 2 niveaux (M > 2) au moyen d'une mémoire RRAM de type MLC.

## Revendications

**1.** Méthode de calcul d'une opération MAC pour fournir le produit scalaire entre un premier vecteur, dont les éléments sont des valeurs binaires, et un second vecteur dont les éléments sont des valeurs quantifiées sur $M > 2$ niveaux, ladite opération étant réalisée au moyen d'une mémoire composée de cellules mémoire comportant une pluralité de lignes de mot et une pluralité de lignes de bit, une cellule mémoire reliant chaque ligne de mot à chaque ligne de bit selon une configuration crossbar, chaque cellule mémoire pouvant prendre une pluralité $M$ d'états, chaque état étant associé à une caractéristique courant-tension de la cellule, les cellules mémoire d'une ligne de bit stockant les éléments du second vecteur, **caractérisée en ce que** chaque cellule mémoire est lue en appliquant successivement $M - 1$ tensions $V_{read_1}$, $V_{read_2},..., V_{read_{M-1}}$ sur sa ligne de mot et en lisant les courants de sortie correspondants sur sa ligne de bit, lesdits courants de sortie donnant une représentation sous forme de code thermométrique de l'élément stocké, ladite méthode comprenant :

- une première phase de lecture dans laquelle on sélectionne les lignes de mot correspondant aux éléments du premier vecteur ayant une première valeur binaire (511), on applique (521,541) successivement aux lignes de mot ainsi sélectionnées les tensions $V_{read_1}$, $V_{read_2}$,..., $V_{read_{M-1}}$, on lit les courants de sortie correspondants sur la ligne de bit et on déduit à chaque lecture le nombre de cellules passantes sur cette ligne de bit (531, 551) ;
- une seconde phase de lecture dans laquelle on sélectionne les lignes de mot correspondant aux éléments du premier vecteur ayant une seconde valeur binaire (512), on applique (522,542) successivement aux lignes de mot ainsi sélectionnées les tensions $V_{read_1}$, $V_{read_2}$,..., $V_{read_{M-1}}$, on lit les courants de sortie correspondants sur la ligne de bit et on déduit à chaque lecture le nombre de cellules passantes sur cette ligne de bit (531, 551) ;
- on calcule la différence (620) entre le nombre total de cellules passantes dans la première phase (611) et le nombre total de cellules passantes dans la seconde phase (612) ;
- on corrige la différence ainsi obtenue (630) d'un biais égal à la différence entre le nombre d'éléments du premier vecteur ayant la première valeur binaire et le nombre d'éléments du second vecteur ayant la seconde valeur binaire, pour en déduire ledit produit scalaire entre le premier vecteur et le second vecteur.

2. Méthode de calcul d'une opération MAC selon la revendication 1, **caractérisée en ce que** les cellules mémoires sont réalisées au moyen d'un sélecteur ovonique en série avec un élément résistif pouvant être programmé dans un état de faible résistivité (LRS) ou un élément de haute résistivité (HRS).

3. Méthode de calcul d'une opération MAC selon la revendication 1 ou 2, **caractérisée en ce que** le premier vecteur est un vecteur d'activation dont les éléments sont les valeurs d'activation d'une couche de neurones, les valeurs d'activation pouvant prendre les valeurs +1 ou -1.

4. Méthode de calcul d'une opération MAC selon la revendication 3, **caractérisée en ce que** le second vecteur est un vecteur de coefficients synaptiques de synapses entre ladite couche de neurones et la couche suivante d'un réseau de neurones quantifié sur $M$ niveaux.

5. Méthode de calcul d'une opération MAC selon la revendication 4, **caractérisée en ce que** les $M$ valeurs quantifiées possibles des coefficients synaptiques sont égales à $$-1, -1 + \frac{2}{M-1}, .., 1 - \frac{2}{M-1}, +1$$ .

6. Méthode de calcul d'une opération MAC selon la revendication 5, **caractérisée en ce que** le produit scalaire se déduit de la différence entre le nombre total de cellules passantes dans la première phase et le nombre total de cellules passantes dans la seconde phase, corrigée du biais, au moyen d'une opération de normalisation (640) transformant un entier $X$ en une valeur quantifiée de coefficient synaptique, $$-1 + \frac{2}{M-1}X$$ .

7. Méthode de calcul d'une opération MAC selon l'une quelconque des revendications 1 à 6, **caractérisée en ce que** ladite mémoire est une mémoire RRAM de type 1S1R ou une mémoire à trois terminaux.

8. Méthode de calcul d'une opération MAC selon l'une quelconque des revendications 1 à 7, **caractérisée en ce que** ladite mémoire est une mémoire à trois terminaux qui est une mémoire FeFET ou une mémoire flash.

9. Méthode de calcul d'une opération MAC selon l'une quelconque des revendications 1 à 8, **caractérisée en ce que** le sélecteur est un sélecteur à conduction mixte ionique-électronique, un sélecteur à transition métal-isolant, un sélecteur de type diode, ou un sélecteur volatil filamentaire.

FIG. 1

FIG. 2

(N_read open)+               (N_read open)-

# FIG. 3A

# FIG. 3B

| a | G/w | $I_{out}$ | digital output |
|---|---|---|---|
| -1 | $G_{off}$/-1 | $I_{leak}$ | NA |
| -1 | $G_{on}$/+1 | $I_{leak}$ | NA |
| +1 | $G_{off}$/-1 | $I_{HRS}$ | -1 |
| +1 | $G_{on}$/+1 | $I_{LRS}$ | +1 |

## FIG. 3C

| a | G/w | $I_{out}$ | digital output |
|---|---|---|---|
| -1 | $G_{off}$/-1 | $I_{HRS}$ | +1 |
| -1 | $G_{on}$/+1 | $I_{LRS}$ | -1 |
| +1 | $G_{off}$/-1 | $I_{leak}$ | NA |
| +1 | $G_{on}$/+1 | $I_{leak}$ | NA |

## FIG. 3D

$(N_{read1\ open})_+ + (N_{read2\ open})_+$

$(N_{read1\ open})_- + (N_{read2\ open})_-$

FIG. 4A

FIG. 4B

| a | G/w | $I_{out}$ | digital output |
|---|-----|-----------|----------------|
| -1 | $G_{off,off}$/-1 | $I_{leak}$ | NA |
| -1 | $G_{off,on}$/0 | $I_{leak}$ | NA |
| -1 | $G_{on,on}$/+1 | $I_{leak}$ | NA |
| +1 | $G_{off,off}$/-1 | $I_{HRS}$,$I_{HRS}$ | 0 |
| +1 | $G_{on,off}$/+1 | $I_{HRS}$,$I_{LRS}$ | 1 |
| +1 | $G_{on,on}$/+1 | $I_{LRS}$,$I_{LRS}$ | 2 |

FIG. 4C

| a | G/w | $I_{out}$ | digital output |
|---|---|---|---|
| -1 | $G_{off,off}$/-1 | $I_{HRS}, I_{HRS}$ | 0 |
| -1 | $G_{on,off}$/+1 | $I_{HRS}, I_{LRS}$ | 1 |
| -1 | $G_{on,on}$/+1 | $I_{LRS}, I_{LRS}$ | 2 |
| +1 | $G_{off,off}$/-1 | $I_{leak}$ | NA |
| +1 | $G_{off,on}$/0 | $I_{leak}$ | NA |
| +1 | $G_{on,on}$/+1 | $I_{leak}$ | NA |

# FIG. 4D

selection of the positive activation values —511

application of a first reading voltage to the word lines corresponding to the positive activation values —521

reading of the output current
$(N_{\text{read1 open}})+$ —531

application of a (M-1)th reading voltage to the word lines corresponding to the positive activation values —541

reading of the output current
$(N_{\text{read(M-1) open}})+$ —551

611

FIG. 5A

selection of the negative activation values — 512

application of a first reading voltage to the word lines corresponding to the negative activation values — 522

reading of the output current
$(N_{read1\ open})$- — 532

application of a (M-1)th reading voltage to the word lines corresponding to the negative activation values — 542

reading of the output current
$(N_{read(M-1)\ open})$- — 552

612

FIG. 5B

EP 4 283 621 A1

611 → total number of passing cells during the readings corresponding to the positive activation values

$$\sum_{m=1}^{M-1}\left(N_{\text{read}_m \text{ open}}\right)_{+}$$

612 → total number of passing cells during the readings corresponding to the negative activation values

$$\sum_{m=1}^{M-1}\left(N_{\text{read}_m \text{ open}}\right)_{-}$$

620 → $\sum$

$+$ $-$

631 → number of positive activation values

$$\sum a_i^{+}$$

630 → correction for the activation bias

632 → number of negative activation values

$$\sum a_i^{-}$$

640 → $$X \rightarrow -1 + \frac{2}{M-1}X$$

a.w

FIG. 6

Europäisches
Patentamt

European
Patent Office

Office européen
des brevets

# RAPPORT DE RECHERCHE EUROPEENNE

Numéro de la demande

EP 23 17 4669

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2019/362787 A1 (LU WEI [US] ET AL) 28 novembre 2019 (2019-11-28) * alinéa [0048] – alinéa [0054]; figures 4-6 * | 1-9 | INV. G11C11/54 G11C13/00 G11C11/56 |
| A | HUNG JE-MIN ET AL: "Challenges and Trends inDeveloping Nonvolatile Memory-Enabled Computing Chips for Intelligent Edge Devices", IEEE TRANSACTIONS ON ELECTRON DEVICES, IEEE, USA, vol. 67, no. 4, 1 avril 2020 (2020-04-01), pages 1444-1453, XP011779978, ISSN: 0018-9383, DOI: 10.1109/TED.2020.2976115 [extrait le 2020-03-23] * alinéa [000V]; figure 9 * | 1-9 | |

**DOMAINES TECHNIQUES RECHERCHES (IPC)**

G11C

Le présent rapport a été établi pour toutes les revendications

| Lieu de la recherche | Date d'achèvement de la recherche | Examinateur |
|---|---|---|
| La Haye | 3 octobre 2023 | Lecoutre, Renaud |

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 23 17 4669

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

03-10-2023

| Document brevet cité au rapport de recherche | Date de publication | Membre(s) de la famille de brevet(s) | Date de publication |
|---|---|---|---|
| US 2019362787 A1 | 28-11-2019 | CN 112154506 A | 29-12-2020 |
| | | EP 3797416 A1 | 31-03-2021 |
| | | KR 20210000313 A | 04-01-2021 |
| | | TW 202013213 A | 01-04-2020 |
| | | US 2019362787 A1 | 28-11-2019 |
| | | US 2021210138 A1 | 08-07-2021 |
| | | WO 2019226289 A1 | 28-11-2019 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2019362787 A

**Littérature non-brevet citée dans la description**

- **H. LI et al.** Memristive crossbar arrays for storage and computing applications. *Adv. Intell. Syst.,* vol. 3 (2100017), 1-26
- **S.N. TRUONG.** Single crossbar array of memristors with bipolar inputs for neuromorphic image recognition. *IEEE Access,* vol. 8, 69327-69332

- **J-M. HUNG ; X. LI, J. WU ; M-F. CHANG.** Challenges and Trends inDeveloping Nonvolatile Memory-Enabled Computing Chips for Intelligent Edge Devices. *IEEE Transactions on Electron Devices,* Avril 2020, vol. 67 (4), 1444-1453
- **E. ESMANHOTTO et al.** High-density monolithically integrated multiple 1T1R multiple-level cell for neural networks. *IEEE International Electron Devices Meeting (IEDM) Proc.,* Décembre 2020, 36.5.1-36.5.4